**Europäisches Patentamt**

**European Patent Office**

**Office européen des brevets**

(19)

(11) Numéro de publication: **0 153 250**
**B1**

(12)

# FASCICULE DE BREVET EUROPEEN

(45) Date de publication du fascicule du brevet:
**28.10.87**

(51) Int. Cl.⁴: **H 03 F 3/30,** H 03 F 1/32

(21) Numéro de dépôt: **85400278.9**

(22) Date de dépôt: **15.02.85**

(54) **Amplificateur intégré à étage de sortie réalisé en technologie CMOS.**

(30) Priorité: **21.02.84 FR 8402572**

(43) Date de publication de la demande:
**28.08.85 Bulletin 85/35**

(45) Mention de la délivrance du brevet:
**28.10.87 Bulletin 87/44**

(84) Etats contractants désignés:
**DE FR GB IT NL**

(73) Titulaire: **THOMSON SEMICONDUCTEURS, 101, bld Murat, F-75016 - Paris (FR)**

(72) Inventeur: **Tallaron, Louis, THOMSON-CSF SCPI -173, bld Haussmann, F-75379 Paris Cedex 08 (FR)**

(74) Mandataire: **Guérin, Michel et al, THOMSON-CSF SCPI 19, avenue de Messine, F-75008 Paris (FR)**

(56) Documents cités:
**WO - A - 82/02128**

**PATENTS ABSTRACTS OF JAPAN, vol. 2, no. 127, 25 octobre 1978, page 7632E78**
**PATENTS ABSTRACTS OF JAPAN, vol. 8, no. 123 (E-249)[1560], 8 juin 1984**
**ELECTRONIC ENGINEERING, vol. 51, no. 622, mai 1979, pages 28,33,35, Londres, GB; D. HOFFMAN: "Driving VMOS power FETs"**
**IEEE TRANSACTIONS ON CONSUMER ELECTRONICS, vol. CE-28, no. 4, novembre 1982, pages 546-552, New York, US; B. ROEHR: "A simple direct-coupled power MOSFET audio amplifier topology featuring bias stabilization"**

## Description

La présente invention concerne l'étage de sortie d'un amplificateur destiné à être réalisé sous forme de circuit intégré en tecnologie CMOS (Métal-Oxyde-Semiconducteur-Complémentaire).

Pour adopter un compromis entre une bonne linéarité d'amplification pour les petits signaux et une faible consommation de puissance de l'étage de sortie au repos (pour un signal nul à l'entrée), on est amené parfois à faire fonctionner l'étage de sortie d'un amplificateur en classe AB, c'est-à-dire d'une manière telle que le point de repos corresponde à une consommation de courant qui n'est pas nulle (ce qui serait le cas en classe B) mais qui est nettement plus faible que la moitié su courant maximum que peut fournir l'étage de sortie (alors qu'en classe A la consommation au repos serait supérieure à cette valeur). En classe B comme en classe AB, on utilise en principe deux transistors montés en «push-pull», c'est-à-dire que l'un fournit les courants positifs et l'autre absorbe les courants négatifs.

Dans le brevet européen 0 052 040, on à décrit un exemple d'étage de sortie fonctionnant en classe AB de manière tout-a-fait satisfaisante, mais qui à l'inconvénient de nécessiter pour son fonctionnement la présence d'un étage d'amplification différentielle de tension, avec deux tipes d'inconvénients: encombrement relativement important (plusieurs transistors sont nécessaires) et temps de réponse non optimal car incluant celui de l'étage différentiel.

La présente invention propose un étage de sortie destiné à fonctionner en classe AB et à être réalisé en technologie CMOS, qui évite les inconvénients des circuits actuellement connus et notamment des deux inconvénients ci-dessous.

Cet étage de sortie comporte une entrée, une sortie et deux bornes d'alimentation, ainsi qu'un premier et un second transistors MOS d'un premier type de canal, reliés an série entre les deux bornes d'alimentation, la sortie étant prélevée au point de jonction de la source du premier et du drain du second. La source et la grille du premier transistor sont reliées respectivement à la source et la grille d'un troisième transistor MOS de même type de canal dont le drain est relié à une première source de courant, la grille des premiers et troisième transistors étant reliée à l'entrée de l'étage de sortie, un quatrième transistor MOS, de type de canal opposé, ayant sa source reliée au drain du troisième et son drain relié à une deuxième source de courant ainsi qu'à la grille du deuxième transistor.

Ainsi, au lieu que la tension d'entrée de l'étage soit recopiée par un transistor suiveur et que la tension de sortie de l'étage soit asservie, par un amplificateur de tension différentielle, à la tension de sortie du transistor suiveur, on a ici un asservissement à partir du courant existant dans le premier transistor de l'ensemble push-pull: ce courant est recopié dans un transistor de recopie, et il est comparé à un courant d'une source de polarisation de la grille de l'autre transistor de l'ensemble push-pull, de sorte que les variations de courant dans le transistor de recopie, lequel est directement commandé par l'entrée de signal de l'étage, induisent des variations de courant modifiant le potentiel de polarisation du deuxième transistor de l'ensemble push-pull.

Le circuit est particulièrement simple et de plus il présente une grande rapidité de réponse aux variations du signal d'entrée car, pour les alternances positives, le signal d'entrée est directement appliquée à la grille d'un des transistors de l'ensemble push-pull, et pour les alternances négatives, ce signal induit immédiatement une variation de courant qui charge la grille de l'autre transistor de l'ensemble push-pull.

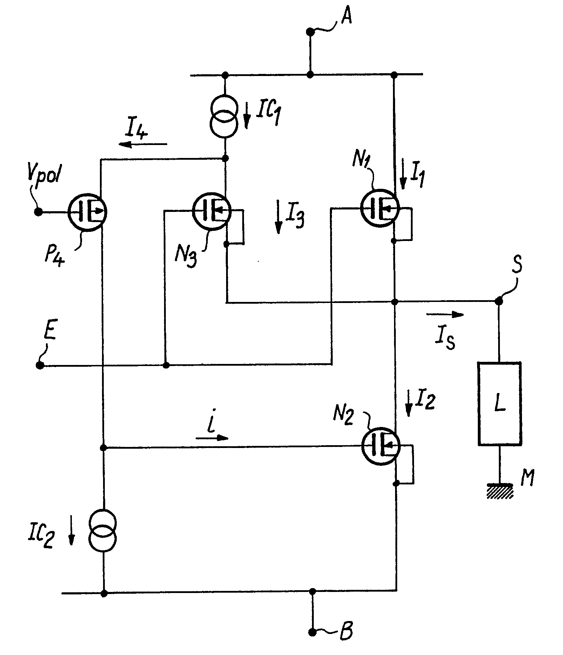

D'autres caractéristiques et avantages de l'invention apparaîtront à la lecture de la description détaillée qui suit et qui est faite en référence au dessin annexée qui représente l'étage de sortie selon l'invention.

Sur la figure, deux bornes d'alimentation sont désignées par A et B, l'entrée de l'étage par E (recevant la sortie d'un préamplificateur de signal non représenté), la sortie de l'étage par S, avec une charge de préférence capacitive L connectée entre la sortie et une borne M à un potentiel fixe intermédiaire entre celui de la borne A et celui de la borne B.

Un transistor MOS N1 et un transistor MOS N2, tous deux à canal N dans l'exemple représenté, forment un ensemble push-pull. Le drain du transistor N1 est relié à la borne A, sa source est reliée au drain du transistor N2 et à la sortie S, et la source du transistor N2 est reliée à la borne B.

Un transistor N3, à canal N, a sa grille reliée a l'entrée E et à la grille du transistor N1, et a sa source reliée à la source du transistor N1; son drain est relié à une source de courant constant IC1 qui lui amène un courant tiré de la borne d'alimentation A; le drain du transistor N3 est également relié à la source d'un transistor MOS P4, à canal P, dont le drain est reliée a une source de courant constant IC2 qui dérive vers la borne B un courant constant. Le transistor P4 est à canal P et sa grille est alimentée par un potentiel de polarisation fixe Vpol intermédiaire entre les potentiels des bornes d'alimentation A et B. Enfin, la grille du transistor N2 est reliée au drain du transistor P4.

Les courants dans les transistors N1, N2, N3, P4 ont été désignés par I1, I2, I3, I4 respectivement; ceux des sources de courant IC1 et IC2 sont désignés par les références de ces sources. Le courant de sortie dans la charge est IS et on a désigné par i un courant transitoire susceptible de circuler vers la grille du deuxième transistor N2 de l'ensemble push-pull.

Le circuit fonctionne de la manière suivante:

1°) au repos, c'est-à-dire sans variation de tension à l'entrée E, le courant dans le transistor N3 est $I3 = IC1 - IC2$, fixe et imposé par les sources de courant IC1 et IC2. Le courant dans le transistor N1 est $I1 = kI3 = k(IC1 - IC2)$, k étant un rapport fixé par les dimensions relatives des transistors N1 et N3.

Le potentiel de la sortie S au repos suit donc, avec un écart constant, le potentiel de l'entrée E, de manière que les courants I3 et I1 conservent les valeurs définies ci-dessus.

Par le choix des valeurs des courants IC2 et IC1, par exemple avec $IC1 = 2IC2$, et par le choix des géometries relatives des transistors N1 et N3, on fixe donc à volonté le courant de repos $I1 + I3$ de l'étage.

2°) Lorsque la tension d'entrée croît, cette ten-

sion est instantanément transmise aux grilles des transistors N1 et N3, augmentant la tension grille-source de ces transistors et augmentant donc simultanément et proportionnellement les courants I1 et I3.

L'augmentation de I3 se traduit par une réduction du courant 14 qui résulte de la différence entre le courant IC1 constant et le courant I3 qui augmente. Comme le courant 14 est tiré essentiellement par la source constante IC2, la seule possibilité de compensation de la réduction du courant 14 reside dans la circulation (transitoire) d'un courant issu de la grille du transistor N2 (courant i négatif).

Autrement dit, une augmentation du courant I3, sous l'effet d'une croissance de la tension a l'entrée de l'étage, se traduit par une décharge de la grille du transistor N2 qui se comporte comme une capacité chargée. Cette décharge se truduit trè rapidement par une chute de la tension grille-source de ce transistor, donc une chute du courant I2.

On a donc simultanément augmentation des courants I3 et I1 et diminution du courant I2, d'ou il résulte une augmentation du courant de sortie IS (avec IS = I1 + I3 – I2) dans la charge. Ce courant se stabilise très rapidement dès que le potentiel de la sortie S a suffisamment augmenté pour rattraper (avec toujours le même écart constant) le potentiel de l'entrée, car alors les courants I3 et I1 reviennent a leur valeur de repos et le corant de compensation i devient nul et cesse de décharger la grille du transistor N2.

3°) Lorsque la tension d'entrée décroît, cette tension est instantanément transmise aux grilles des transistors N1 et N3, diminuant leur tension grille-source et diminuant simultanément et proportionnellement les courants I1 et I3.

De la même manière que précédemment, cette diminution de I3 se traduit nécessairement par un courant de compensation transitoire i, qui cette fois charge la grille du transistor N2 au lieu de la décharger.

Il en résulte une augmentation du courant I2, qui cumulée avec la diminution des courants I1 et I3, produit une diminution du courant de sortie IS (IS = I1 + I3 – I2) en même temps que le potentiel e sortie baisse pour tendre à suivre le potentiel d'entrée décroissant.

Le circuit est tous particulièrement adapté au cas ou la charge L est capacitive: l'étage de sortie ne présente pas de gain en tension mais est capable de produire un courant important en fonction du signal de tension appliqué.

Pour éviter des rebondissements lorsque la tension d'entrée varie trop brutalement, on peut augmenter artificiellement le temps de réponse du transistor N2 en connectant une capacité de stabilisation entre sa grille et sa source ou sa grille et son drain.

Plus le transistor N2 a une géométrie importante, plus il peut écouler un courant I2 important lors de la décroissance de la tension d'entrée: si I2 peut etteindre une valeur égale a deux fois la valeur de repos de I1 + I3, le courant de sortie IS peut varier alors entre (I1 + I3) et –(I1 + I3).

## Revendications

1. Amplificateur comprenant un étage de sortie fonctionnant en classe AB et réalisé en technologie MOS, cet étage de sortie comportant une entrée (E), une sortie (S), deux bornes d'alimentation (A et B), un premier et un second transistors MOS (N1 et N2) d'un premier type de canal (N) en série entre les deux bornes d'alimentation , la sortie étant prélevée au point de jonction de la source du premier transistor (N1) et du drain du second (N2), caractérisé en ce que la source et la grille du premier transistor sont réliées respectivement à la source et la grille d'un troisième transistor MOS (N3) de même type de canal, dont le drain est relié à une première source de courant (IC1), les grilles des premier et troisième transistors étant reliées à l'entrée (E) de l'étage de sortie, un quatrième transistor MOS (P4), de type de canal opposé, ayant sa source reliée au drain du troisième transistor et son drain relié à une deuxième source de courant (IC2) ainsi qu'à la grille du deuxième transistor (N2).

2. Amplificateur selon la revendication 1, caractérisé en ce que la première source de courant (IC1) fournit un courant de l'ordre du double de la seconde (IC2).

## Patentansprüche

1. Verstärker mit einer Ausgangsstufe, die im Klasse AB-Betrieb arbeitet und in MOS-Technologie ausgeführt ist, wobei die Ausgangsstufe einen Eingang (E), einen Ausgang (S), zwei Versorgungsanschlüsse (A und B), einen ersten und einen zweiten MOS-Transistor (N1 und N2) eines ersten Kanaltyps (N) in Reihe zwischen den beiden Versorgungsanschlüssen enthält, und wobei der Ausgang am Verbindungspunkt der Source des ersten Transistors (N1) mit dem Drain des zweiten (N2) abgenommen wird, dadurch gekennzeichnet, dass die Source und das Gate des ersten Transistors jeweils mit der Source und dem Gate eines dritten MOS-Transistors (N3) desselben Kanaltyps verbunden sind, dessen Drain mit einer ersten Stromquelle (IC1) verbunden ist, wobei die Gates des ersten und dritten Transistors mit dem Eingang (E) der Ausgangsstufe verbunden sind, und wobei ein vierter MOS-Transistor (P4) des entgegengesetzten Kanaltyps an seiner Source mit dem Drain des dritten Transistors und an seinem Drain mit einer zweiten Stromquelle (IC2) sowie mit dem Gate des zweiten Transistors (N2) verbunden ist.

2. Verstärker nach Anspruch 1, dadurch gekennzeichnet, dass die erste Stromquelle (IC1) einen Strom liefert, der in der Grössenordnung des doppelten der zweiten (IC2) liegt.

## Claims

1. Amplifier comprising an output stage operating in class AB and embodied in MOS technology, this output stage comprising an input (E), an output (S) two supply terminals (A and B), a first and a second MOS transistor (N1 and N2) of a first channel type (N) in series between the two supply terminals, the output being derived at the junction point of the source of the first transistor (N1) and the drain of the second (N2), characterized in that the source and gate of the first transistor are respectively connected to the source and to the gate of a third MOS transistor (N3) of the same channel type and the drain of which is connected to a first current source (IC1), the gates of the first and third transistors being connected to the input (E) of the output stage, a fourth MOS transistor (P4) of the opposite channel type having its source connected to the drain of the third transistor and its drain connected to a second current source (IC2) as well as to the gate of the second transistor (N2).

2. Amplifier according to claim 1, characterized in that the first current source (IC1) supplies a current of the order of twice that of the second (IC2).